# EUROPEAN PATENT APPLICATION

(11) **EP 4 492 684 A1**
(43) Date of publication of application: **15.01.2025**
(21) Application number: 24186519.5
(22) Date of filing: 04.07.2024
(51) Int. Cl.: H03K 3/012, H03K 3/356

(54) **LEVEL SHIFTER CIRCUIT**

(30) Priority: 11.07.2023 US 202318350586
(71) Applicant: NXP USA, Inc., Austin TX 78735 (US)
(72) Inventor: Lin, Weiting, 5656AG Eindhoven (NL)
(74) Representative: Krott, Michel

(57) **Abstract**

One example discloses a level shifter circuit, including: an input port configured to receive an input signal (IN); an output port configured to transmit an output signal (OUT); a delay circuit coupled to generate a delayed input signal (IN_DLY) from the input signal (IN); a pulse generator coupled to the delay circuit and configured to generate a pulse signal from a combination of the input signal and the delayed input signal; and a latch circuit coupled to the pulse generator and configured to generate and hold a state of the output signal in response to the pulse signal.

## Description

The present specification relates to systems, methods, apparatuses, devices, articles of manufacture and instructions for level shifting voltages.

### SUMMARY

According to an example embodiment, a level shifter circuit, comprising: an input port configured to receive an input signal (IN); an output port configured to transmit an output signal (OUT); a delay circuit coupled to generate a delayed input signal (IN_DLY) from the input signal (IN); a pulse generator coupled to the delay circuit and configured to generate a pulse signal from a combination of the input signal and the delayed input signal; and a latch circuit coupled to the pulse generator and configured to generate and hold a state of the output signal in response to the pulse signal.

In another example embodiment, the pulse generator is coupled to the input port and configured to generate a pulse signal in response to either a rising edge or a falling edge of the input signal.

In another example embodiment, the state of the output signal is a first state in response to a rising edge of the input signal; and the state of the output signal is a second state in response to a falling edge of the input signal.

In another example embodiment, the pulse generator includes a switch (MN_IN) coupled to a logical AND circuit.

In another example embodiment, the switch is configured to send the pulse signal to the latch circuit in response to a control signal from the logical AND circuit.

In another example embodiment, the logical AND circuit is configured to generate the control signal if both the input signal and the delayed input signal have a same signal state.

In another example embodiment, the logical AND circuit and the switch are configured to generate the pulse signal in response to a rising edge of the input signal and a rising edge of the delayed input signal.

In another example embodiment, the logical AND circuit and the switch are configured to generate the pulse signal in response to a falling edge of the input signal and a falling edge of the delayed input signal.

In another example embodiment, a first instance of the pulse signal sets the state of the output signal from the latch circuit to a first state; and a second instance of the pulse signal sets the state of the output signal from the latch circuit to a second state.

In another example embodiment, the output signal (OUT) has a higher voltage than the input signal (IN).

In another example embodiment, a driver circuit comprises a level shifter circuit of the kind set forth; wherein the output port is coupled to a load, and the output voltage is configured to activate the load.

In another example embodiment, further comprising a converter circuit configured to generate a first differential input signal (IN_A) and a second differential input signal (IN_B) from the input signal (IN).

In another example embodiment, the delay circuit includes a first delay chain configured to generate a first delayed input signal (IN_A_DLY) from the first differential input signal (IN_A); and the delay circuit includes a second delay chain configured to generate a second delayed input signal (IN_B_DLY) from the second differential input signal (IN_B).

In another example embodiment, the first delay chain and the second delay chain are cross-coupled using NAND gates.

In another example embodiment, the pulse generator is a first pulse generator coupled to the first delay circuit and configured to generate a first differential latch signal (Xn) from a combination of the first delayed input signal (IN_A_DLY) and the first differential input signal (IN_A).

In another example embodiment, further comprising a second pulse generator coupled to the second delay circuit and configured to generate a second differential latch signal (Xp) from a combination of the second delayed input signal (IN_B_DLY) and the second differential input signal (IN_B).

In another example embodiment, the latch circuit is a first differential latch circuit coupled to the first and second pulse generators; and the first differential latch circuit is configured to generate and hold a state of the output signal in response to the first differential latch signal (Xn) and the second differential latch signal (Xp).

In another example embodiment, a second differential latch circuit configured to generate and hold the state of the output signal in response to differential signals output from the first differential latch circuit; and a third differential latch circuit configured to generate and hold the state of the output signal in response to differential signals output from the second differential latch circuit.

In another example embodiment, further comprising a first clamping circuit coupled to the first pulse generator and a second clamping circuit coupled to the second pulse generator; wherein the first and second clamping circuits are configured to keep the first differential latch signal (Xn) and the second differential latch signal (Xp) above minimum signal voltages.

The above discussion is not intended to represent every example embodiment or every implementation within the scope of the current or future Claim sets. The Figures and Detailed Description that follow also exemplify various example embodiments.

Various example embodiments may be more completely understood in consideration of the following Detailed Description in connection with the accompanying Drawings.

### BRIEF DESCRIPTION OF THE DRAWINGS

Figure 1 represents a first example of a level shifter circuit.
Figures 2A, 2B and 2C represents a second example of the level shifter circuit.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

### DETAILED DESCRIPTION

Level shifters are a frequently used circuit in many modern electronic circuits. Applications include translating signals between various communication domains and driver circuits. Frequently level shifters are asked to drive high voltage devices (e.g. 15-20V) using much lower voltage input signals (e.g. 2.5-5.5V). Yet such circuits are also increasingly asked to have very low quiescent (e.g. standby, static, etc.) currents during an absence of signal transitions.

Many level shifters use constant bias currents for pulling down and up their high voltage output signals. However, there is often a tension between low quiescent currents and fast output signal transition times (e.g. shorter propagation delays), with faster transitions requiring higher quiescent currents.

Gate driver level shifters particularly may consume large static currents (e.g. in the milli-Amp range), which results in a significant quiescent power loss. Modern electrical devices however are increasingly required to have lower quiescent currents, greater light load efficiency, and smaller propagation delays.

Now discussed are example embodiments of level shifters having substantially reduced quiescent (e.g. standby, static, etc.) current consumption (e.g. in the micro-Amp range) while still enabling faster level shift signal transitions.

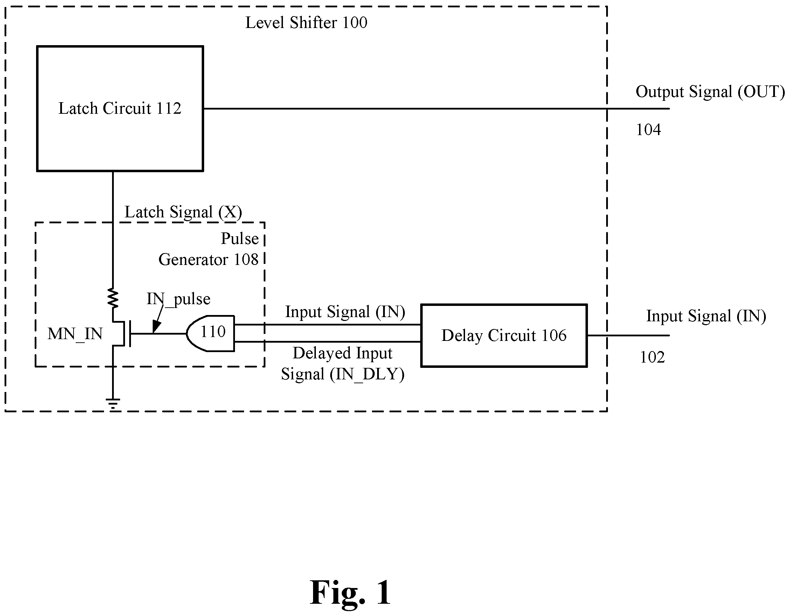

Figure 1 represents a first example 100 of a level shifter circuit. The first example level shifter circuit 100 includes an input port 102 for receiving an input signal (IN), an output port 104 for transmitting an output signal (OUT), a delay circuit 106, a pulse generator 108, and a latch circuit 112.

The delay circuit 106 is configured to generate a delay input signal bar (IN_DLY_BAR) from the input signal (IN).

The pulse generator 108, in combination with the delay circuit 106, is configured to generate a very short transitory latch signal (X) from the input signal (IN) which has an effect of substantially reducing quiescent power drain and current from the pulse generator 108 and thus from the first example level shifter circuit 100 as well.

This example embodiment of the pulse generator 108 includes a logical AND circuit 110 and a switch MN_IN. The logical AND circuit 110 enables rising and falling edges of the input signal (IN) in combination with the delayed input signal (IN_DLY) to generate a very short pulse (IN_PULSE). The IN_PULSE signal will turn on switch MN_IN which then becomes the very short transitory latch signals (X).

The pulse generator 108 is coupled to the input port 102 and is configured to generate the very short pulse signal in response to either a rising edge or a falling edge of the input signal (IN). The switch MN_IN is configured to generate the very short latch signal (X) sent to the latch circuit 112 in response to the IN_PULSE signal (e.g. a control signal) from the logical AND circuit.

The logical AND circuit 110 is configured to generate the IN_PULSE signal if both the input signal (IN) and the delayed input signal (IN_DLY) have a same signal state. For example, the logical AND circuit and the switch are configured to generate the very short pulse (IN_PULSE) in response to a rising edge of the input signal and a rising edge of the delayed input signal. Also the logical AND circuit 110 and the switch are configured to generate the very short pulse (IN_PULSE) in response to a falling edge of the input signal and a falling edge of the delayed input signal.

The latch circuit 112 is coupled to the pulse generator 108 and configured to generate and hold a state of the output signal (OUT) in response to the very short pulse of the latch signal (X). A first instance of the very short pulse of the latch signal (X) sets the state of the output signal from the latch circuit 112 to a first state, and a second instance of the very short pulse of the latch signal (X) sets the state of the output signal from the latch circuit 112 to a second state.

Example embodiments of the level shifter 100 consumes larger currents only during input signal (IN) transition, and thus reduces static quiescent pull down currents regardless of the level shifter's 100 input voltage, output voltage and operational speed.

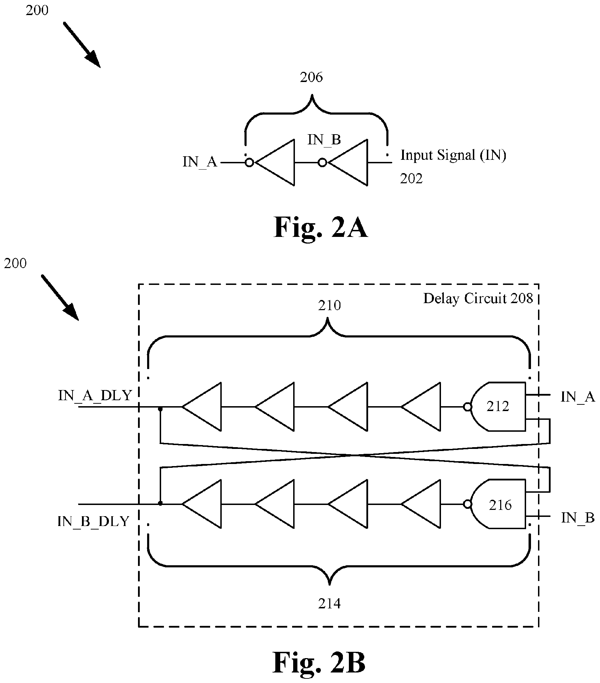

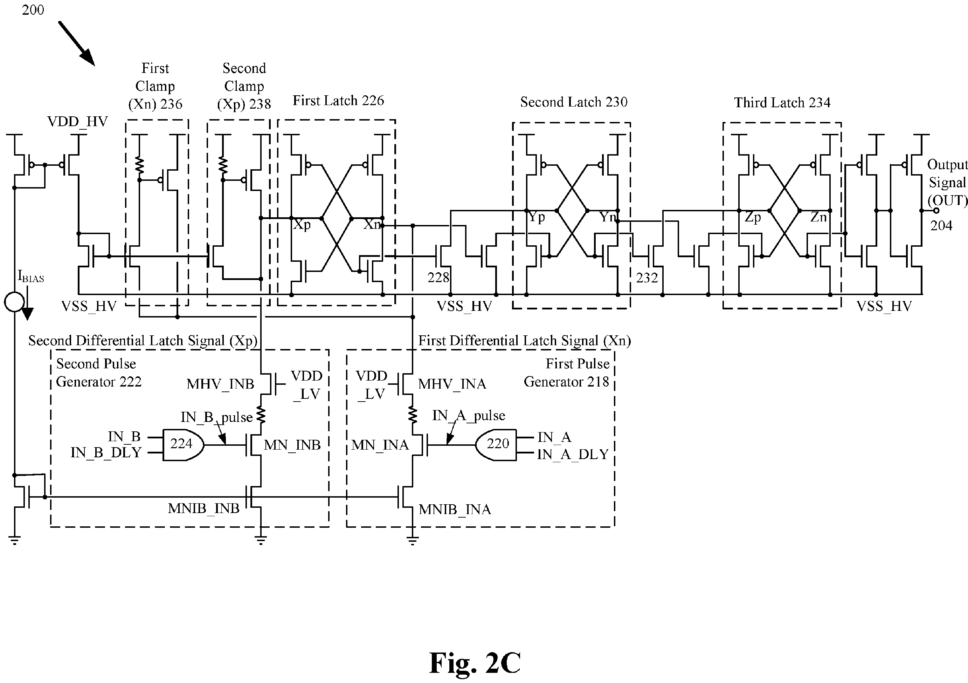

Figures 2A, 2B and 2C represents a second example 200 of the level shifter circuit. The second example level shifter circuit 200 includes input port 202 for receiving an input signal (IN), an output port 204 for transmitting an output signal (OUT), an inverter circuit 206, a delay circuit 208, a first pulse generator 218, a second pulse generator 222, a first latch circuit 226, a second latch circuit 230, a third latch circuit 234, a first clamp low circuit 236, and a second clamp low circuit 238.

The inverter circuit 206 is configured to generate a first differential input signal (IN_A) and a second differential input signal (IN_B) from the input signal (IN). This example embodiment of the inverter circuit 206 generates IN_B as the input signal (IN) through an inverter, and IN_A as the input signal (IN) through a buffer including two inverters. Those skilled in the art will recognize other example embodiments of the inverter circuit 206 that can also generate IN_A and IN_B from the input signal (IN).

The delay circuit 208 includes a first delay chain configured to generate a first inverse delayed input bar signal (IN_A_DLY_BAR) from the first differential input signal (IN_A), and a second delay chain configured to generate a second inversed delayed input signal (IN_B_DLY) from the second differential input signal (IN_B).

In this example embodiment of the first delay chain 210 (IN_A_DLY) includes a set of buffers and a first NAND gate 212. The second delay chain 214 (IN_B_DLY) also includes a set of buffers and a second NAND gate 216.

The first and second delay chains 210, 214 are cross-coupled through the NAND gates 212 and 216. By this method, the delay cell number can be saved, because the IN_A_DLY must wait IN_B_DLY go high then through delay chain then go low. Can use 8 delay cell for first and second side.

Those skilled in the art will recognize other example embodiments of the delay circuit 208 that can also generate IN_A_DLY and IN_B_DLY from IN_B and IN_A.

The first and second pulse generators 218, 222, in combination with the inverter circuit 206 and the delay circuit 208, are configured to generate very short transitory first and second differential latch signals (Xn/Xp) from the input signal (IN) which has an effect of substantially reducing quiescent power drain and current from the first and second pulse generators 218, 222 and thus from the second example level shifter circuit 200 as well.

This example embodiment of the first pulse generator 218 includes a first logical AND circuit 220, a switch MN_INA, a switch MNIB_INA, and a switch MHV_INA.

The first logical AND circuit 220 enables rising and falling edges of the IN_A signal in combination with the IN_A_DLY signal to generate a first very short pulse (IN_A_PULSE). Similarly the second logical AND circuit 224 enables rising and falling edges of the IN_B signal in combination with the IN_B_DLY signal to generate a second very short pulse
(IN_B_PULSE).

The IN_A_PULSE and IN_B_PULSE signals will respectively turn on switch MN_INA and switch MN_INB which then become the very short transitory first and second differential latch signals (Xn/Xp).

Switches MHV_INA and MHV_INB gate the first and second differential latch signals (Xn/Xp) are controlled by an enable signal (VDD_LV).

Switch MNIB_INA limits an input bias (IB) current flowing in the first differential latch signal (Xn). Switch MNIB_INB limits an input bias (IB) current flowing in the second differential latch signal (Xp).

When the MN_INA is switched on the first differential latch signal (Xn) will be pulled logic low, and when the MN_INA is switched off the first differential latch signal (Xn) will will follow the first latch 226 state. Similarly when the MN_INB is switched on the second differential latch signal (Xp) will be pulled logic low, and when the MN_INB is switched off the second differential latch signal (Xp) will follow the first latch 226 state.

Those skilled in the art will recognize other example embodiments of the first and second pulse generators 218, 222 that can also generate the first and second differential latch signals (Xn/Xp) from first and second very short pulses (IN_A_PULSE) and (IN_B_PULSE).

The first differential latch signal (Xn) and second differential latch signal (Xp) are held at a steady logic state by the first latch circuit 226 which receives the VDD_HV and VSS_HV voltage domains.

Once first differential latch signal (Xn) is pulled down, the second differential latch signal (Xp) will be pulled up by the first latch circuit's 226 architecture.

The second differential latch signal (Xp) going high will drive NMOS switch 228 to pull down node Yp which will in turn then pull up node Yn at the second latch circuit 230.

Yn will drive NMOS switch 232 to pull down node Zn which will in turn then pull up node Zp at the third latch circuit 234.

Signal Zp then passes through two inverter circuits to become the output signal (OUT) on the output port 204.

The second example level shifter 200 includes these three latch circuits 226, 230, 234 to increase signal noise immunity, however, in other example embodiments of the level shifter fewer or a greater number of latch circuits may be used.

The first clamp circuit 236 and second clamp circuit 238 prevent the first differential latch signal (Xn) and the second differential latch signal (Xp) from going lower than VSS_HV minus diode voltage drop (0.7V) in response to the IN_A_PULSE and the IN_B_PULSE signal switching transitions that can cause various NMOS parasitic body diodes to turn on.

Using the above circuits the quiescent current of the first and second example level shifter circuits 100, 200 is minimized during steady state when the input signal (IN) is not transitioning. Many example embodiments of the level shifter 100 have quiescent currents less than 5uA, which is substantially lower than conventional level shifter/driver circuits. The driver current can be measured via driver VDD pin or boot pin.

Various instructions and/or operational steps discussed in the above Figures can be executed in any order, unless a specific order is explicitly stated. Also, those skilled in the art will recognize that while some example sets of instructions/steps have been discussed, the material in this specification can be combined in a variety of ways to yield other examples as well, and are to be understood within a context provided by this detailed description.

In some example embodiments these instructions/steps are implemented as functional and software instructions. In other embodiments, the instructions can be implemented either using logic gates, application specific chips, firmware, as well as other hardware forms.

When the instructions are embodied as a set of executable instructions in a non-transitory computer-readable or computer-usable media which are effected on a computer or machine programmed with and controlled by said executable instructions. Said instructions are loaded for execution on a processor (such as one or more CPUs). Said processor includes microprocessors, microcontrollers, processor modules or subsystems (including one or more microprocessors or microcontrollers), or other control or computing devices. A processor can refer to a single component or to plural components. Said computer-readable or computer-usable storage medium or media is (are) considered to be part of an article (or article of manufacture). An article or article of manufacture can refer to any manufactured single component or multiple components. The non-transitory machine or computer-usable media or mediums as defined herein excludes signals, but such media or mediums may be capable of receiving and processing information from signals and/or other transitory mediums.

It will be readily understood that the components of the embodiments as generally described herein and illustrated in the appended figures could be arranged and designed in a wide variety of different configurations. Thus, the detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms without departing from its spirit or essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

## Claims

1. A level shifter circuit, comprising:
an input port configured to receive an input signal (IN);
an output port configured to transmit an output signal (OUT);
a delay circuit coupled to generate a delayed input signal (IN_DLY) from the input signal (IN);
a pulse generator coupled to the delay circuit and configured to generate a pulse signal from a combination of the input signal and the delayed input signal; and
a latch circuit coupled to the pulse generator and configured to generate and hold a state of the output signal in response to the pulse signal.

2. The level shifter circuit of claim 1:
wherein the pulse generator is coupled to the input port and configured to generate a pulse signal in response to either a rising edge or a falling edge of the input signal.

3. The level shifter circuit of claim 1 or 2:
wherein the state of the output signal is a first state in response to a rising edge of the input signal; and
wherein the state of the output signal is a second state in response to a falling edge of the input signal.

4. The level shifter circuit of any preceding claim:
wherein the pulse generator includes a switch (MN_IN) coupled to a logical AND circuit.

5. The level shifter circuit of claim 4:
wherein the switch is configured to send the pulse signal to the latch circuit in response to a control signal from the logical AND circuit.

6. The level shifter circuit of claim 5:
wherein the logical AND circuit is configured to generate the control signal if both the input signal and the delayed input signal have a same signal state.

7. The level shifter circuit of any one of claims 4 to 6:
wherein the logical AND circuit and the switch are configured to generate the pulse signal in response to a rising edge of the input signal and a rising edge of the delayed input signal.

8. The level shifter circuit of any one of claims 4 to 6:
wherein the logical AND circuit and the switch are configured to generate the pulse signal in response to a falling edge of the input signal and a falling edge of the delayed input signal.

9. The level shifter circuit of any preceding claim:
wherein a first instance of the pulse signal sets the state of the output signal from the latch circuit to a first state; and
wherein a second instance of the pulse signal sets the state of the output signal from the latch circuit to a second state.

10. The level shifter circuit of any preceding claim:
wherein the output signal (OUT) has a higher voltage than the input signal (IN).

11. A driver circuit, comprising:
the level shifter circuit of any preceding claim; and
wherein the output port is coupled to a load, and the output voltage is configured to activate the load.

12. The level shifter circuit of any one of claims 1 to 10:
further comprising a converter circuit configured to generate a first differential input signal (IN_A) and a second differential input signal (IN_B) from the input signal (IN).

13. The level shifter circuit of claim 12:
wherein the delay circuit includes a first delay chain configured to generate a first delayed input signal (IN_A_DLY) from the first differential input signal (IN_A); and
wherein the delay circuit includes a second delay chain configured to generate a second delayed input signal (IN_B_DLY) from the second differential input signal (IN_B).

14. The level shifter circuit of claim 13:
wherein the first delay chain and the second delay chain are cross-coupled using NAND gates.

15. The level shifter circuit of claim 13 or 14:
wherein the pulse generator is a first pulse generator coupled to the first delay circuit and configured to generate a first differential latch signal (Xn) from a combination of the first delayed input signal (IN_A_DLY) and the first differential input signal (IN_A).
